# FASCICULE DE BREVET EUROPEEN

(11) **EP 0 585 175 B1**
(45) Date de publication et mention de la délivrance du brevet: **11.11.1998**
(21) Numéro de dépôt: 93402094.2
(22) Date de dépôt: 25.08.1993
(51) Int. Cl.: G01R 31/34

(54) **Dispositif et procédé pour mesurer le vieillissement d'un isolant composite polymère pour bobine de stator**
Anordnung und Verfahren für das Messen der Alterung einer Isolation aus Polymergemischen für Statorwicklungen
Appliance and method for measuring the aging of composite polymer insulation for a stator winding

(30) Priorité: 27.08.1992 FR 9210315
(43) Date de publication de la demande: 02.03.1994
(73) Titulaire: GEC ALSTHOM MOTEURS SA, 54062 Nancy Cédex (FR)
(72) Inventeur: Pons, Alain, F-91290 Ollainville (FR); Lucas, Jean-Paul, F-91720 Valpuiseaux (FR)
(74) Mandataire: Fournier, Michel

(56) Documents cités:
- EP-A- 0 234 167
- CA-A- 1 078 017
- PERIODICA POLYTECNICA,ELECTRICAL ENGINEERING vol. 14, no. 1, 1970, BUDAPEST,HU pages 15 - 20 L.SCHNELL 'Neue Moeglichkeiten zur Ueberwachung des Isolationszustandes von Elektrischen Hochspannungsmaschinen in Betrieb'

## Description

L'invention se rapporte à un dispositif et à un procédé pour mesurer le vieillissement d'un matériau diélectrique dans une machine, notamment un isolant composite polymère pour bobine de stator.

Une des principales causes électriques de la défaillance des moteurs électriques est la rupture ou la dégradation de l'isolation des stators provoquant selon les sources de 30 à 50% des pannes en service des moteurs. Le vieillissement de l'isolation est dû aux différentes contraintes qui lui sont appliquées (électrique, thermique, mécanique) dont certaines sont mal connues comme les transitoires des convertisseurs de puissance.

L'isolation de ces stators est généralement constituée en un matériau diélectrique en composite polymère, tel qu'une résine époxy micacée. Jusqu'à présent, le contrôle de l'isolation des stators de moteurs électriques est réalisé par des tests spécifiques portant sur les phases du moteur. L'inconvénient de ces tests est qu'ils nécessitent un arrêt complet de la machine.

On a proposé de remédier à cet inconvénient dans l'art antérieur par une méthode décrite dans le document PERIODICA POLYTECNICA ELECTRICAL ENG. Vol. 14, No 1, 1970, BUDAPEST HU page 15-20.

Ce document décrit une méthode mettant en oeuvre un dispositif de mesure du vieillissement d'un matériau diélectrique de générateurs, moteurs ou transformateurs en fonction. Cette méthode propose de mesurer un courant différentiel représentatif du vieillissement dudit matériau d'isolation.

L'invention concerne un dispositif pour mesurer le vieillissement d'un matériau diélectrique dans une machine, notamment un isolant polymère pour bobine de stator, comportant des moyens dans ledit matériau diélectrique pour faire une mesure sur site pendant le fonctionnement de la machine d'une grandeur physique sensible au vieillissement dudit matériau caractérisé en ce que lesdits moyens de mesure comprennent deux électrodes incluses dans ledit matériau et séparées l'une de l'autre par celui-ci pour constituer un condensateur et un circuit relié aux électrodes pour mesurer l'angle de pertes du condensateur.

La propriété physique exploitée réside dans le fait que l'angle de pertes d'une isolation augmente lorsque cette isolation vieillit. Si un condensateur est constitué avec le matériau diélectrique considéré, le matériau diélectrique n'étant pas parfait, le circuit équivalent représentant le condensateur réel est constitué d'un condensateur parfait avec, en parallèle, une résistance de pertes. L'expérience montre que la valeur de cette résistance équivalente évolue avec le vieillissement du diélectrique.

Selon un mode de réalisation, le circuit de mesure comporte au moins une bobine pour constituer un circuit oscillant avec le condensateur, un moyen d'excitation du circuit oscillant, un moyen de dérivation d'un signal électrique résultant de l'excitation du circuit oscillant et représentatif de son facteur de surtension à la fréquence de résonance du circuit oscillant, et un dispositif servant à évaluer ledit facteur de surtension.

Un tel dispositif est simple, fiable et bon marché.

L'excitation du circuit oscillant consiste en une impulsion électrique brève, le moyen de dérivation fournissant un signal représentatif de l'amortissement dans le temps de la tension oscillante du circuit oscillant.

Le dispositif comprend en outre un comparateur servant à comparer ledit facteur de surtension évalué avec celui représentatif d'un matériau diélectrique ayant une capacité d'isolation acceptable.

L'invention s'étend à un procédé pour mesurer le vieillissement d'un matériau diélectrique isolant des spires d'une bobine d'une machine électrique qui soumettent le matériau diélectrique à un champ électrique, caractérisé par le fait qu'il consiste:
- à placer au moment du bobinage des spires deux électrodes le long d'une spire de la bobine, ces électrodes étant séparées par le matériau diélectrique pour constituer un condensateur, et
- à mesurer l'angle de pertes du condensateur pendant le fonctionnement de la machine.

Le procédé selon l'invention peut donc être utilisé dans le cadre d'une maintenance prédictive de ces machines, les variations de l'angle de pertes du condensateur dans le temps renseignant sur l'espérance statistique de vie de la machine surveillée. Le condensateur formant un capteur peut être utilisé sur une machine en fonctionnement car il est très peu sensible au champ de fonctionnement normal des bobines statoriques.

De plus les électrodes peuvent être utilisées comme antenne dans un système de mesure des décharges partielles. Le prix de revient de l'insertion de deux électrodes est très faible si cette insertion est prévue au cours de la construction du stator, ce qui rend le procédé adapté pour des machines de coût modéré.

Les deux électrodes sont placées entre deux spires consécutives de la bobine ou entre la dernière spire et la masse ce qui permet de mesurer l'état de l'isolation entre spires ou l'état de l'isolation masse.

L'invention est décrite en détail ci-dessous en référence aux figures.
- La figure 1 représente schématiquement le dispositif selon l'invention.
- La figure 2 représente deux spires d'une bobine équipée d'un capteur de mesure selon l'invention.
- La figure 3 est un graphe donnant l'angle de pertes d'un condensateur pour différentes valeurs de tension et à différents stades de son vieillissement.
- La figure 4 est un graphe donnant l'évolution de la tension aux bornes du capteur de mesure.

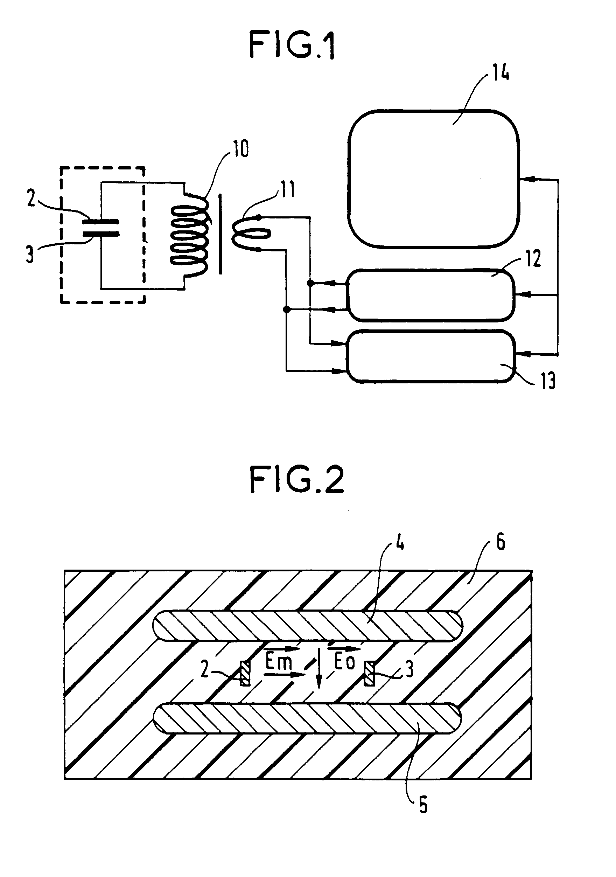

Sur la figure 1, le dispositif de mesure comprend un capteur constitué de deux électrodes 2,3 pour former un condensateur avec un matériau diélectrique et un circuit relié aux électrodes pour mesurer l'angle de pertes du condensateur. Comme visible sur la figure 2, pour la mesure du vieillissement d'un isolant de stator, les électrodes 2,3 sont des fils méplats de cuivre parallèles entre eux qui sont insérés entre deux conducteurs statoriques consécutifs 4,5 à un endroit ou l'isolant 6 se trouve sous contrainte électrique pendant le fonctionnement de la machine. les deux électrodes 2,3 sont insérés au moment du bobinage en écartant légèrement les conducteurs statoriques. Elles sont séparées par le matériau diélectrique. Ce dernier est soumis aux mêmes conditions que le reste du matériau dans le stator, donc il est dans le même état de vieillissement. Elles peuvent tout aussi bien être insérées entre le dernier conducteur de la bobine et le ruban carboné. Dans le premier cas, le capteur mesure l'isolation entre spires et dans le second cas, le capteur mesure l'isolation masse.

Le diélectrique du condensateur est soumis à un champ électrique comportant deux composantes. La composante principale Eo est due à la tension appliquée à l'isolation. Cette tension est celle qui intervient dans le processus de vieillissement de l'isolant. La composante de mesure Em est d'amplitude négligeable et est perpendiculaire à la précédente. Dans cette configuration, le champ électrique de fonctionnement ne génère aucune différence de tension entre les électrodes 2,3 du condensateur de mesure, ces électrodes parallèles entre elles et perpendiculaires au champ Em se trouvant portées à un potentiel intermédiaire par rapport aux potentiels des conducteurs statoriques 4,5 entres lesquels elles sont insérées.

Le circuit de mesure comporte une bobine primaire 10 reliée aux électrodes 2,3 pour constituer un circuit oscillant avec le condensateur. Il comprend aussi une bobine secondaire 11 couplée magnétiquement avec la bobine primaire pour former un moyen d'excitation du circuit oscillant, les bobines étant disposées sur des noyaux de transformateur pour éliminer toute liaison galvanique. Le potentiel du circuit oscillant peut donc être quelconque s'il est compatible avec l'isolement entre les deux bobines du circuit oscillant. La bobine secondaire 11 est reliée d'une part à un générateur d'impulsions 12, et d'autre part à un dispositif d'analyse 14 au travers d'un convertisseur analogique numérique 13. Le signal électrique résultant de la stimulation par le générateur 12 est numérisé par le convertisseur 13 et analysé par le dispositif 14 de façon à obtenir une mesure du facteur de surtension à la fréquence de résonance du circuit oscillant. Le facteur de surtension mesuré est représentatif de l'amortissement du signal dérivé par le convertisseur 13. Le dispositif 14 comporte aussi un comparateur pour comparer le facteur de surtension évalué avec celui représentatif d'un matériau diélectrique ayant une capacité d'isolation acceptable. Le dispositif 14 peut être un système à microprocesseur tel qu'un micro-ordinateur classique en soi.

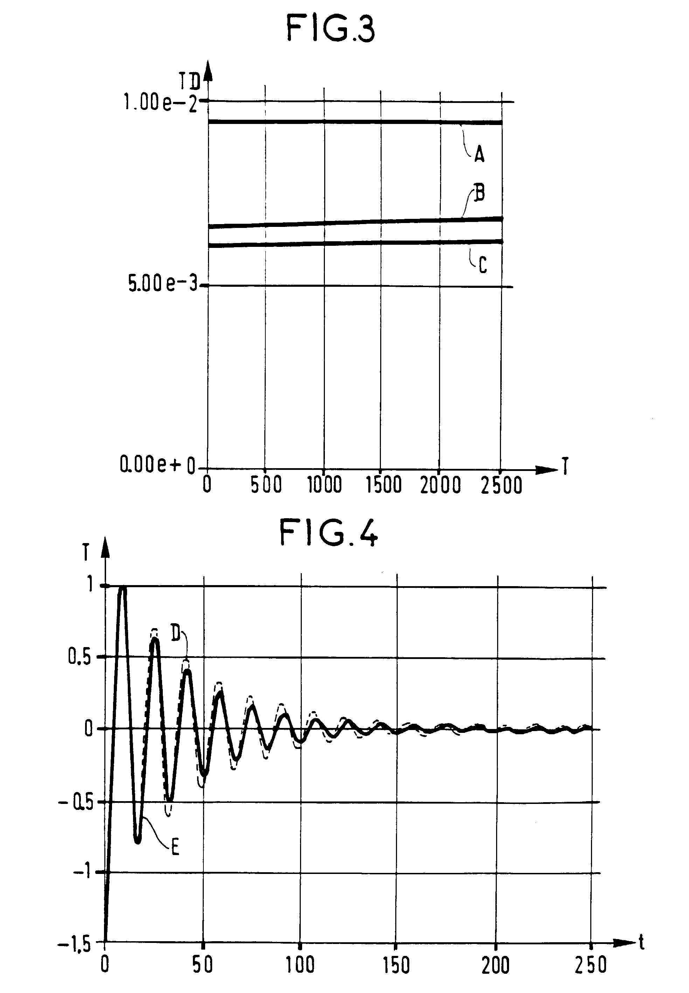

La figure 3 représente la variation de l'angle de pertes ( axe désigné par TD) de l'isolant d'une bobine soumis à un vieillissement accéléré, en fonction d'une tension de fonctionnement exprimée en volts (axe désigné par T) . La courbe C représente la variation de l'angle de pertes pour une bobine neuve. La courbe B représente la variation de l'angle de pertes pour la bobine après 1000 heures de fonctionnement et la courbe A représente la variation de l'angle de pertes pour la bobine après 7600 heures de fonctionnement.

En soumettant le circuit oscillant à une impulsion électrique brève, ce circuit répond par une oscillation sinusoïdale amortie dont le décrément logarithmique est fonction de l'angle de pertes. Les résultats d'un essai effectué en insérant deux électrodes dans un isolant du type polymère micacé sont montrés sur la figure 4. Une dégradation de l'isolant a été obtenue en plongeant celui-ci dans de l'eau désionisée à 80°C. L'axe T désigne la tension normée appliquée sur les conducteurs statoriques 4,5 et l'axe t désigne le temps de conduction en microsecondes. La courbe D (en trait pointillé) représente l'évolution de la tension normée pour un échantillon frais et la courbe E (en trait plein) représente l'évolution de la tension normée pour un échantillon ayant séjourné 96 heures dans l'eau. Comme visible sur cette figure la courbe E s'amortit plus vite que la courbe D. Ces courbes sont invariantes avec la tension appliquée sur les conducteurs statoriques. Par conséquent, en connaissant l'évolution de la valeur de l'angle de pertes pour un diélectrique depuis l'état neuf jusqu'à sa défaillance et la mesure de cette valeur à un instant donné, un système informatique convenablement programmé peut évaluer statistiquement la durée de vie restante et prévenir d'une défaillance prochaine de l'isolation d'un système électrotechnique à isolation solide.

Le principe de l'invention est aussi applicable à un transformateur imprégné par exemple ou à tout matériel électrotechnique utilisant un isolant solide, dès que le positionnement des électrodes du capteur reste possible.

## Revendications

1. Dispositif pour mesurer le vieillissement d'un matériau diélectrique dans une machine, notamment un isolant polymère pour bobine de stator, comportant des moyens dans ledit matériau diélectrique pour faire une mesure sur site pendant le fonctionnement de la machine d'une grandeur physique sensible au vieillissement dudit matériau, caractérisé en ce que lesdits moyens de mesure comprennent deux électrodes (2,3) incluses dans ledit matériau et séparées l'une de l'autre par celui-ci pour constituer un condensateur et un circuit (10,11,12,13,14) relié aux électrodes pour mesurer l'angle de pertes du condensateur.

2. Dispositif selon la revendication 1, dans lequel le circuit de mesure comporte au moins une bobine (10) pour constituer un circuit oscillant avec le condensateur, un moyen d'excitation (11,12) du circuit oscillant, un moyen de dérivation (13) d'un signal électrique résultant de l'excitation du circuit oscillant et représentatif de son facteur de surtension à la fréquence de résonance du circuit oscillant, et un dispositif (14) servant à évaluer ledit facteur de surtension.

3. Dispositif selon la revendication 2, dans lequel l'excitation du circuit oscillant consiste en une impulsion électrique brève, le moyen de dérivation fournissant un signal représentatif de l'amortissement dans le temps de la tension oscillante du circuit oscillant.

4. Dispositif selon l'une des revendications 2 ou 3, comprenant en outre un comparateur (14) servant à comparer ledit facteur de surtension évalué avec celui représentatif d'un matériau diélectrique ayant une capacité d'isolation acceptable.

5. Procédé pour mesurer le vieillissement d'un matériau diélectrique (6) isolant des spires (4,5) d'une bobine de machine électrique qui soumettent le matériau diélectrique à un champ électrique, caractérisé par le fait qu'il consiste:
- à placer au moment du bobinage des spires deux électrodes (2,3) le long d'une spire de la bobine, ces électrodes étant séparées par le matériau diélectrique pour constituer un condensateur, et
- à mesurer l'angle de pertes du condensateur pendant le fonctionnement de la machine.

6. Procédé selon la revendication 5, dans lequel les deux électrodes sont placées entre deux spires consécutives de la bobine ou entre la dernière spire et la masse.

## Patentansprüche

1. Vorrichtung zum Messen der Alterung eines dielektrischen Materials in einer Maschine, insbesondere einer Polymerisolation für eine Statorwicklung, mit Mitteln in dem dielektrischen Material zum Durchführen einer Messung einer für die Alterung des Materials empfindlichen physikalischen Größe vor Ort während des Betriebes der Maschine, **dadurch gekennzeichnet**, daß die Mittel zum Messen zwei Elektroden (2,3), die in dem Material eingeschlossen und voneinander durch dieses getrennt sind, um einen Kondensator zu bilden, und eine mit den Elektroden verbundene Schaltung (10, 11, 12, 13, 14) zum Messen des Verlustwinkels des Kondensators umfassen.

2. Vorrichtung nach Anspruch 1, bei der die Meßschaltung wenigstens eine Wicklung (10) zum Bilden einer Schwingschaltung mit dem Kondensator, ein Mittel zum Erregen (11, 12) der Schwingschaltung, ein Mittel zum Ableiten (13) eines aus der Erregung der Schwingschaltung resultierenden und für ihren Überspannungsfaktor bei der Resonanzfrequenz der Schwingschaltung repräsentativen elektrischen Signals und eine Vorrichtung (14) zum Auswerten des Überspannungsfaktors umfaßt.

3. Vorrichtung nach Anspruch 2, bei der die Erregung der Schwingschaltung aus einem kurzen elektrischen Impuls besteht und das Mittel zum Ableiten ein für die zeitliche Dämpfung der oszillierenden Spannung der Schwingschaltung repräsentatives Signal liefert.

4. Vorrichtung nach einem der Ansprüche 2 oder 3, ferner mit einem Komparator (14), der dazu dient, den ausgewerteten Überspannungsfaktor mit demjenigen zu vergleichen, der für ein dielektrisches Material mit einer akzeptablen Isolationsfähigkeit repräsentativ ist.

5. Verfahren zum Messen der Alterung eines dielektrischen Materials (6), wobei das dielektrische Material Windungen (4, 5) einer Wicklung einer elektrischen Maschine isoliert, die das dielektrische Material einem elektrischen Feld aussetzen, gekennzeichnet durch die Schritte:
- Anbringen von zwei Elektroden (2, 3) entlang einer Windung der Wicklung beim Wickeln der Windungen, wobei die Elektroden durch das dielektrische Material getrennt sind, um einen Kondensator zu bilden und
- Messen des Verlustwinkels des Kondensators während des Betriebes der Maschine.

6. Verfahren nach Anspruch 5, bei dem die zwei Elektroden zwischen zwei aufeinander folgenden Windungen der Wicklung oder zwischen der letzten Windung und der Masse angeordnet sind.

## Claims

1. Apparatus for measuring the ageing of a dielectric material in a machine, in particular a polymer insulator for a stator winding, the apparatus comprising, in said dielectric material, measurement means for measuring a physical magnitude that is responsive to the ageing of said material, the measurement being taken in situ while the machine is operating, said apparatus being characterized in that said measurement means comprise two electrodes (2, 3) included in said material and separated from each other thereby so as to constitute a capacitor, and a circuit (10, 11, 12, 13, 14) connected to the electrodes and for measuring the loss angle of the capacitor.

2. Apparatus according to claim 1, in which the measurement circuit comprises at least one winding (10) so as to constitute an oscillatory circuit with the capacitor, excitation means (11, 12) for exciting the oscillatory circuit, derivation means (13) for deriving an electrical signal resulting from the oscillatory circuit being excited and representative of the Q factor of the oscillatory circuit at the resonance frequency thereof, and apparatus (14) serving to evaluate said Q factor.

3. Apparatus according to claim 2, in which the oscillatory circuit is excited by a short electrical pulse, the derivation means delivering a signal representative of the damping over time of the oscillatory voltage of the oscillatory circuit.

4. Apparatus according to claim 2 or 3, further comprising a comparator (14) serving to compare said Q factor as evaluated with the Q factor that is representative of a dielectric material providing acceptable insulation.

5. A method of measuring the ageing of a dielectric material (6) insulating the turns (4, 5) of an electrical machine winding, which turns subject the dielectric material to an electric field, said method being characterized by the fact that it consists in:
placing two electrodes (2, 3) along a turn of the winding while the turns are being wound, the electrodes being separated by the dielectric material so as to constitute a capacitor; and
measuring the loss angle of the capacitor while the machine is operating.

6. A method according to claim 5, in which the two electrodes are placed between two consecutive turns of the winding, or between the last turn and ground.
